# EUROPEAN PATENT SPECIFICATION

(11) **EP 0 589 524 B1**
(45) Date of publication and mention of the grant of the patent: **09.07.1997**
(21) Application number: 93202701.4
(22) Date of filing: 17.09.1993
(51) Int. Cl.: H01S 3/025, H01L 33/00

(54) **Method of manufacturing an optoelectronic semiconductor device and optoelectronic semiconductor element suitable for use in such a method**
Verfahren zur Herstellung einer optoelektronischen Halbleiteranordnung und für die Anwendung bei einem derartigen Verfahren geeignetes optoelektronisches Halbleiterelement
Procédé de fabrication d'un dispositif semiconducteur optoélectronique et dispositif semiconducteur optoélectronique convenant pour être utilisé dans un tel procédé

(30) Priority: 25.09.1992 EP 92202949
(43) Date of publication of application: 30.03.1994
(73) Proprietor: Philips Electronics N.V., 5621 BA Eindhoven (NL)
(72) Inventor: van de Pas, Hermanus Antonius, NL-5656 AA Eindhoven (NL); Tijburg, Rudolf Paulus, NL-5656 AA Eindhoven (NL); De Poorter, Johannes Antonius, NL-5656 AA Eindhoven (NL)
(74) Representative: Smeets, Eugenius Theodorus J. M.

(56) References cited:
- PATENT ABSTRACTS OF JAPAN vol. 8, no. 49 (E-230)6 March 1984 & JP-A-58 201 389
- PATENT ABSTRACTS OF JAPAN vol. 6, no. 264 (E-150)23 December 1982 & JP-A-57 159 078
- PATENT ABSTRACTS OF JAPAN vol. 8, no. 49 (E-230)6 March 1984 & JP-A-58 201 388
- PATENT ABSTRACTS OF JAPAN vol. 14, no. 273 (E-940)13 June 1990 & JP-A-02 086 184
- PATENT ABSTRACTS OF JAPAN vol. 16, no. 116 (E-1181)17 December 1991 & JP-A-03 286 547

## Description

The invention relates to a method of manufacturing an optoelectronic semiconductor device which comprises an optoelectronic semiconductor element - usually called element hereinafter for short -, which element provided with a first contact surface is fastened to a carrier provided with a second contact surface, the element being so fastened on the carrier that the two contact surfaces enclose an angle with one another which substantially deviates from zero degrees and an electrical connection between the two contact surfaces is formed by at least one round wire and by means of wire bonding. The invention also relates to an element suitable for use in such a method.

Such a method is frequently used in the manufacture of, for example, a semiconductor diode laser comprising optoelectronic devices which form part of a read and/or write head of information-processing equipment such as laser printers, bar code readers, read and/or write devices for optical registration carriers such as CD (Audio) and CDROM (data) discs and of systems for optical glass fibre communication. The desired direction of a radiation beam from and to such an element often demands such a spatial orientation of the element that a contact surface of the element will have an angled position relative to a contact surface of the carrier after its fastening on this carrier. When a wire connection is to be made between the two contact surfaces by means of a wire bonding unit, accordingly, at least one of these contact surfaces will be at an angle relative to the head of the wire bonding unit. The provision of a wire connection by means of a wire bonding unit thus becomes problematic or even impossible.

A method of the kind mentioned in the opening paragraph is known from JP(A) 2-86184 published in Patent Abstracts of Japan, vol. 13, no. 273(E-940){4216} of 13th June 1990. This describes and shows how an element, *i.e.* a diode laser 1, is so mounted on a carrier 3 that the radiation beam of the diode laser 1 is perpendicular to the carrier 3, so that a first contact surface of the diode laser 1, here the upper surface thereof, is at right angles to a second contact surface present on the carrier 3, here the upper surface of a pin 11 provided in the carrier. An electrical connection between the two contact surfaces is formed here by two wire connections and an interposed insulating block 6 on which two mutually perpendicular and interconnected conductor tracks 5a, 5b are present. The two wire connections may be readily made by means of a wire bonding unit. This is because each wire connection is laid between two parallel surfaces, *i.e.* between the upper surface of pin 11 and the surface of track 5b, and between the upper surface of diode laser 1 and the surface of track 5a. The problem of providing an electrical connection between two contact surfaces which are at an angle relative to one another is solved in this manner.

A disadvantage of the known method is that it is laborious and expensive. Indeed, two wire connections are made, the device or the wire bonding unit must be rotated between making of the wire connections, and an additional component is used. Naturally, optoelectronic devices manufactured by the known method are expensive as a result.

Patent Abstracts of Japan, vol.8, no. 49 (E-230) [1486], March 6, 1984 and JP-A-58 201 389 disclose a method according to the preamble of claim 1.

The present invention has for its object *inter alia* to provide a method of the kind mentioned in the opening paragraph by which a wire connection is obtained between two contact surfaces which are at an angle relative to one another in a simple and inexpensive manner and by means of a wire bonding unit.

According to the invention as defined in claim 1, a method of the kind mentioned in the opening paragraph is for this purpose characterized in that the electrical connection is formed in that a round wire in a wire bonding apparatus is provided with a first free end which is then fastened to one of the two contact surfaces, the whole round wire is provided with an angle towards the contact surface to which it is attached which is chosen approximately equal to the angle which the contact surfaces will enclose after fastening of the element on the carrier, after fastening of the first free end to the one contact surface the round wire is provided with a second free end and, after fastening of the element on the carrier, the second free end of the round wire is fastened to the other contact surface. The invention is based *inter alia* on the recognition that the problem of making a wire connection between two contact surfaces which enclose an angle is solved by providing the wire connection in two steps. In a first step, one of the two contact surfaces is provided with a round wire - usually called wire hereinafter for short - of which only one end is fastened to the element, and the other end is rendered free. This is realised in that first a wire is fastened on the one contact surface by means of a wire bonding unit, and then this wire is cut off at a distance from the element, for example, by means of a device utilizing a flame or spark. The element is fastened on the carrier before or after the wire is applied. The element is so tilted in the method that an orientation desired for the optical operation is achieved. This implies that the first contact surface (of the element) and the second contact surface (of the carrier), between which the wire connection is desired, will also be at an angle relative to one another. The free end of the wire at the same time comes in the vicinity of the other contact surface during this. In a second step, preferably also by means of a wire bonding unit, the free end of the wire is fastened to the other contact surface. Providing the wire with the required angle and with the second free end are preferably also done in the latter step. Wire length is preferably chosen so that it corresponds at least to the distance to be bridged between the two contact surfaces. According to the invention, one single wire bond between two contact surfaces enclosing an angle with one another is thus realised in a very simple manner and without the use of additional components.

In an important preferred embodiment, the wire having the first free end is applied to the first contact surface, and thus to the element, before the element is fastened on the carrier. After this the element is fastened on the carrier, and then the free end of the wire is fastened to the second contact surface. Since the contact surface on the carrier is usually much larger than the contact surface on the element, the alignment of the free end of the wire relative to the contact surface of the carrier is much less critical, thanks to the previous application of the wire to the contact surface of the element, than in the opposite case. This renders the method according to the invention easier and therefore cheaper. The application of the wire to the element before the fastening thereof on the carrier has the further advantage that the wire can be provided more easily because the element has not yet been tilted then. Finally, the method according to this embodiment has the important advantage that in this manner the element is (substantially) not exposed to external forces anymore after the wire has been applied, by which forces optoelectronic elements, especially diode lasers, can very easily become damaged. This implies that testing of the element and the provision of the wire thereon forms a reliable indication for the end product. This possibility of an intermediate and reliable test will cause the reject rate of the comparatively expensive end product to be lower.

Especially when the element is a diode laser, it will preferably be fastened on a support body, which may also function as a heat sink, and the support body is tilted and fastened to the carrier with a side surface which encloses the angle with the first contact surface. The risk of damage to the diode laser during its manipulation and fastening is reduced by this, as it is reduced by the provision of the wire on the diode laser before the fastening thereof on the carrier. This renders the intermediate test referred to above even more reliable.

In the method according to the invention, the angle towards the contact surface to which it is fastened provided to the wire is chosen to be approximately equal to the angle which the two contact surfaces will enclose after fastening of the element on the carrier. After fastening of the element on the carrier, the wire will run approximately parallel to the other contact surface when such an angle is provided in the wire having the free end. As a result, the free end can be more easily fastened on this contact surface. This renders the latter fastening simpler. The angle may be provided in that the wire bonding unit is moved away from the element in the correct direction and at the desired angle after the wire has been fastened, for example on the element, but before cutting off of the wire. Alternatively, the wire may readily be bent in the correct direction and through the correct angle by means of a suitable instrument after cutting. A suitable instrument, for example, is a two-pronged fork. The wire may also be given the correct angle after the element has been fastened on the carrier. All this illustrates an additional advantage of the method according to the invention, *i.e.* that it is comparatively well suited to mechanisation.

As was noted above, both fastening of the wire on the one contact surface and fastening of the free end on the other contact surface is preferably done by means of thermocompression or ultrasonic bonding. These are simple and reliable techniques which are often at hand already, which has important advantages. Preferably, bump connections are used at least for providing the wire having the free end on the one contact surface. As a result, a wire fastened on a contact surface has a secure base, which enhances the stability of the wire.

The tilting necessary for a good optical operation of the element may be realised in various ways. Preferably, the element or the support body is tilted before being fastened on the carrier and is fastened to the carrier with a side surface of the element or of the support body which encloses an angle with the first contact surface. Tilting may alternatively be achieved in that a portion of the carrier is provided with a sloping surface. The element or support body is then fastened with its bottom surface on this sloping portion.

A method according to the invention is particularly interesting when the two contact surfaces enclose an angle of between 10 and 90° with one another. Between 0 and approximately 10° it is possible to make a direct wire connection between the contact surfaces by means of wire bonding when a gold wire, bump connections and thermocompression bonding are used. In other cases, the maximum value for the angle is even smaller than 10°, for example, approximately 5°.

The invention also relates to an optoelectronic semiconductor element as defined in claim 8, preferably fastened on a support body and fastened on a carrier provided with a contact surface, provided with another contact surface on which a wire is fastened with a first free end, which wire has a second free end and the whole wire being provided with an angle towards the contact surface to which it is attached which is chosen approximately equal to the angle which the contact surfaces enclose after fastening of the element on the carrier. Preferably, such an element forms part of a series of elements which are present on a series of support bodies which are interconnected by means of break-off edges. Large numbers of such support bodies provided with elements and wires may thus be manufactured and tested in this manner. The use of such an element renders the method according to the invention even less expensive. For the method of manufacture of such a series of support bodies, the reader is referred to a European Patent Application filed by Applicant EP-A-0 588 406.

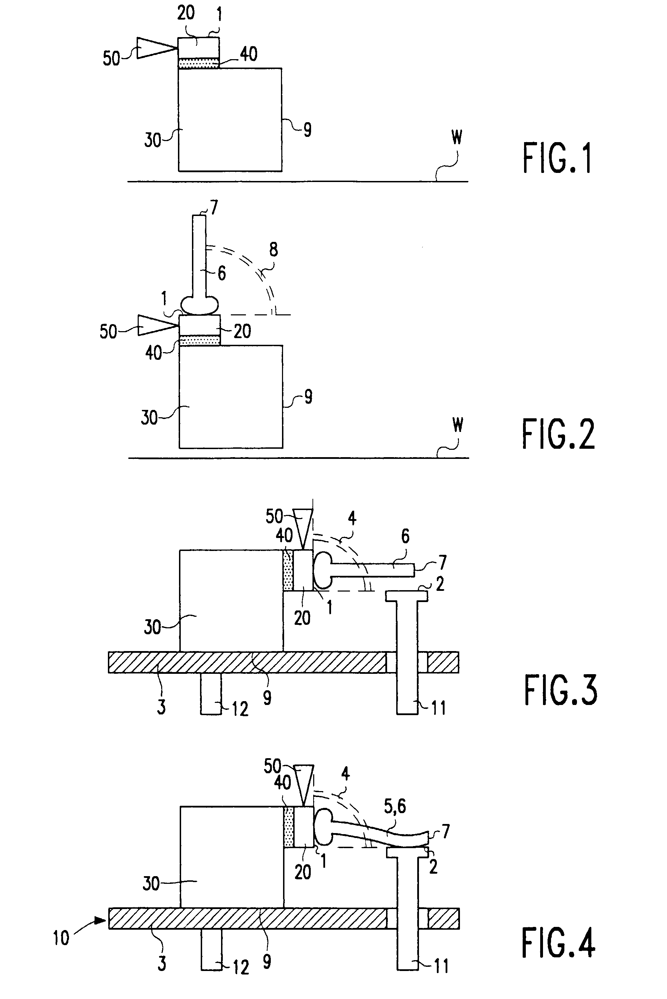

The invention will now be explained in more detail with reference to an embodiment and the accompanying drawing, in which
Figs. 1 to 4 diagrammatically show an embodiment of a method according to the invention for the manufacture of an optoelectronic device comprising an optoelectronic semiconductor element in side elevation and in subsequent stages of the manufacture.

Figs. 1 to 4 diagrammatically show an embodiment of a method according to the invention for the manufacture of an optoelectronic device having an optoelectronic semiconductor element in side elevation and in subsequent stages of the manufacture. On a working surface W (see Fig. 1), an element 20, here a diode laser 20, is fastened on a support body 30, here by means of indium solder 40. The support body 30 comprises a silicon block provided with a titanium and platinum layer and whose dimensions are approximately 1 x 1 x 1 mm³. The diode laser 20 is fastened at the edge of the support body 20 here in order that a radiation beam 50 generated in the diode laser 20 will not be reflected against the body. The diode laser 20 is provided with a first contact surface 1, here formed by the metallized upper surface of the diode laser 20. The diode laser is so fastened on a carrier 3 by means of the support body 30 (see Fig. 4) that the first contact surface 1 encloses an angle 4 with a second contact surface 2 of the carrier 3. The second contact surface 2 is here formed by the upper surface of a pin 11 which is passed through the carrier 3 with electrical insulation. In this example, the angle 4 is 90°, so that the radiation beam 50 will issue from the device perpendicularly to the carrier 3. The contact surfaces 1 and 2 are electrically interconnected by a wire connection 5.

By a method according to the invention (see Fig. 2), a wire 6 having a free end 7 is provided on one of the two contact surfaces 1, 2 - here on the first contact surface 1 -, and after fastening of the diode laser 20 on the carrier 3 (see Fig. 3) the free end 7 of the wire 6 is fastened on the other contact surface 2, 1, in this case on the second contact surface 2. The manufacture of the wire connection 5 in two steps achieves that, in spite of the fact that the contact surfaces 1, 2 enclose an angle 4, only one wire connection 5 is necessary and no additional component is required, which is a great advantage. In addition, usually available wire bonding units such as thermocompression or ultrasonic (bump) wire bonders (not shown in the Figures) can be used for making the wire connection 5, at least during the first step thereof. The second step (fastening the free end 7 on the second contact surface) may also be carried out with a wire bonding unit. These are also important advantages. In the first step, the head of a wire bonding unit (not shown in the Figures) is first moved to above the diode laser 20 and, preferably, a bump connection of the wire 6 on the diode laser 20 is provided. After the head of the wire bonding unit has been moved up, the wire 6 is cut off at the desired length by means of a device (also not shown in the Figures) utilizing a flame or spark, whereby the free end 7 is formed at the wire 6. The provision of the wire provided with the free end 7 on the diode laser 20, *i*.*e*. before the diode laser 20 is fastened on the carrier 3 as in the present example, offers major further advantages: since the second contact surface 2 is usually much larger than the first contact surface 1, the alignment of the free end 7 of the wire 6 relative to the second contact surface 2 is comparatively simple. In addition, (substantially) no external forces are exerted anymore on the diode laser 20 after the wire has been provided. As a result, testing of the diode laser 20 in the stage as depicted in Fig. 2 provides a reliable indication on the end product depicted in Fig. 4. The yield of comparatively expensive final products is increased by such a test. Owing to the comparatively large surface area of the second contact surface 2, the free end 7 of the wire 6 may also be readily fastened thereon with, for example, a glue connection.

The wire 6 having the free end 7 is preferably given an angle 8 relative to the first contact surface 1 (see Fig. 2) which is chosen to be approximately equal to the angle 4 enclosed by the contact surfaces 1, 2 after fastening of the diode laser 20 on the carrier 3 (see Fig. 4). As a result, the wire 6 having the free end 7 runs approximately parallel to the second contact surface 2 after fastening of the diode laser 20, which facilitates the fastening on this second contact surface. The angle 8 may in addition be adapted to a posible difference in spacing between the contact surfaces 1, 2 and the carrier 3. The provision of the angle 8 in the present example has been effected in that, after the wire 6 was provided on the diode laser 20, the head of the wire bonding unit was moved up perpendicularly, followed by cutting off of the wire 6. The angle 8 may alternatively be shaped afterwards or corrected, for example, by means of an instrument suitable for this purpose such as a two-pronged fork. The wire 6 having the free end 7 has a good stability in that the wire was provided on the first contact surface 1 by means of a so-called bump connection.

The support body 30 is here fastened on the carrier 3 by means of a side surface 9, for example, by soldering or with an electrically conducting glue. The second electrical connection of the diode laser 20 is formed here by the electrically conducting support body 30, the carrier 3 which comprises a metal, and a pin 12 also of metal and connected to the carrier 3. It is also possible for the support body 30 to be fastened on a portion of the carrier 3 with its side which rests on the working surface W in Fig. 2. In that case, the relevant portion of the carrier 3 should be given an angle relative to the carrier 3 which is required for the optical operation.

The optoelectronic semiconductor element 20, which is fastened on a carrier 30 here and provided with the wire 6 having the free end 7, as shown in Fig. 2, forms an attractive semimanufactured product for the reasons detailed above and is highly suitable for use in a method according to the invention.

The invention is not limited to the embodiment given, because many modifications and variations are possible to those skilled in the art within the scope of the invention. Besides one or several diode lasers, one or several other optoelectronic elements may be used, such as LEDs (Light Emitting Diodes), photodiodes and phototransistors. An important modification relates to the mounting of an optoelectronic component on a perfectly plane carrier on which plane connection areas are present, as is the case with a PC-board or a board with a flexible foil thereon which is provided with conductor tracks ending in contact pads.

## Claims

1. A method of manufacturing an optoelectronic semiconductor device (10) which comprises an optoelectronic semiconductor element (20), which optoelectronic semiconductor element (20) provided with a first contact surface (1) is fastened to a carrier (3) provided with a second contact surface (2), the optoelectronic semiconductor element (20) being so fastened on the carrier (3) that the two contact surfaces (1, 2) enclose an angle (4) with one another which deviates from zero degrees and an electrical connection between the two contact surfaces (1, 2) is formed by at least one wire (6), characterized in that the electrical connection (5) is formed in that a round wire (6) in a wire bonding apparatus is provided with a first free end which is then fastened to one of the two contact surfaces (1,2), the whole round wire (6) is provided with an angle (8) towards the contact surface (1,2) to which it is attached which is chosen approximately equal to the angle (4) which said contact surfaces (1,2) will enclose after fastening of said optoelectronic element (20) on said carrier (3), after fastening of the first free end to the one contact surface (1,2) the round wire (6) is provided with a second free end (7) and, after fastening of the optoelectronic semiconductor element (20) on the carrier (3), the second free end (7) of the round wire (6) is fastened to the other contact surface (2,1).

2. A method as claimed in Claim 1, characterized in that providing the round wire (6) with the angle (8) and with the second free end (7) and fastening of the second free end (7) of the round wire (6) to the other of the two contact surface (2,1) are done by means of the wire bonding apparatus.

3. A method as claimed in Claim 1 or 2, characterized in that the first free end of the round wire (6) is applied to the first contact surface (1) and thus to the optoelectronic semiconductor element (20), before the optoelectronic semiconductor element (20) is fastened on the carrier (3).

4. A method as claimed in Claim 1, 2 or 3, characterized in that the optoelectronic semiconductor element (20) is fastened on a support body (30), and the support body (30) is tilted and fastened to the carrier (3) with a side surface (9) which encloses the angle (4) with the first contact surface (1).

5. A method as claimed in any one of the preceding Claims, characterized in that the angle (4) enclosed by the two contact surfaces (1, 2) is chosen to lie between 10° and 90°.

6. A method as claimed in any one of the preceding Claims, characterized in that a thermocompression or ultrasonic wire bonding apparatus is chosen as the wire bonding apparatus.

7. A method as claimed in any one of the preceding Claims, characterized in that a semiconductor diode laser (20) is chosen as the optoelectronic semiconductor element (20).

8. An optoelectronic semiconductor element (20), preferably fastened on a support body (30) and fastened on a carrier (3) having a contact surface (2), provided with another contact surface (1) on which a round wire (6) is fastened with a first free end, which round wire (6) has a second free end (7), the whole round wire (6) being provided with an angle (8) towards the contact surface (1) to which it is attached which is chosen approximately equal to the angle (4) which the contact surfaces (1,2) enclose after fastening of the element (20) on the carrier (3).

9. A series of optoelectronic semiconductor elements (20) as claimed in Claim 8, characterized in that the series of optoelectronic semiconductor elements (20) is present on a series of support bodies (30) which are interconnected by means of break-off edges.

## Patentansprüche

1. Verfahren zur Herstellung einer optoelektronischen Halbleiteranordnung (10), die ein optoelektronisches Halbleiterelement (20) umfaßt, welches mit einer ersten Kontaktfläche (1) versehene optoelektronische Halbleiterelement (20) an einem mit einer zweiten Kontaktfläche (2) versehenen Träger (3) befestigt wird, wobei das optoelektronische Halbleiterelement (20) so auf dem Träger (3) befestigt wird, daß die beiden Kontaktflächen (1, 2) miteinander einen Winkel (4) bilden, der von null Grad abweicht, und daß mit zumindest einem Draht (6) eine elektrische Verbindung zwischen den beiden Kontaktflächen (1, 2) gebildet wird, dadurch gekennzeichnet, daß die elektrische Verbindung (5) dadurch gebildet wird, daß ein runder Draht (6) in einem Drahtbondgerät mit einem ersten freie Ende versehen wird, das dann an einer der beiden Kontaktflächen (1, 2) befestigt wird, daß der gesamte runde Draht (6) mit einem Winkel (8) relativ zur Kontaktfläche (1,2), an der er befestigt wird, versehen wird, der ungefähr gleich dem Winkel (4) gewählt wird, den die genannten Kontaktflächen (1,2) nach dem Befestigen des genannten optoelektronischen Elements (20) auf dem genannten Träger (3) miteinander bilden, daß nach dem Befestigen des ersten freien Endes an der einen Kontaktfläche (1, 2) der runde Draht (6) mit einem zweiten freien Ende (7) versehen wird und nach Befestigen des optoelektronischen Halbleiterelements (20) auf dem Träger (3) das zweite freie Ende (7) des runden Drahtes (6) an der anderen Kontaktfläche (2, 1) befestigt wird.

2. Verfahren nach Anspruch 1, dadurch gekennzeichnet, daß das Versehen des runden Drahtes (6) mit einem Winkel (8) und mit dem zweiten freien Ende (7) und das Befestigen des zweiten freien Endes (7) des runden Drahtes (6) an der anderen der beiden Kontaktflächen (2, 1) mit Hilfe eines Drahtbonndgerätes erfolgen.

3. Verfahren nach Anspruch 1 oder 2, dadurch gekennzeichnet, daß das erste freie Ende (7) des runden Drahtes (6) an der ersten Kontaktfläche (1) und somit dem optoelektronischen Halbleiterelement (20) angebracht wird, bevor das optoelektronische Halbleiterelement (20) auf dem Träger (3) befestigt wird.

4. Verfahren nach Anspruch 1, 2 oder 3, dadurch gekennzeichnet, daß das optoelektronische Halbleiterelement (20) auf einem Trägerkörper (30) befestigt wird, und der Trägerkörper (30) gekippt und an dem Träger (3) mit einer Seitenfläche (9) befestigt wird, die mit der ersten Kontaktfläche (1) den Winkel (4) bildet.

5. Verfahren nach einem der vorhergehenden Ansprüche, dadurch gekennzeichnet, daß der von den beiden Kontaktflächen (1, 2) gebildete Winkel (4) zwischen 10 und 90° gewählt wird.

6. Verfahren nach einem der vorhergehenden Ansprüche, dadurch gekennzeichnet, daß ein Thermokompressions- oder Ultraschall-Drahtbondgerät als Drahtbondgerät gewählt wird.

7. Verfahren nach einem der vorhergehenden Ansprüche, dadurch gekennzeichnet, daß ein Halbleiterdiodenlaser (20) als optoelektronisches Halbleiterelement (20) gewählt wird.

8. Optoelektronisches Halbleiterelement (20), das vorzugsweise auf einem Trägerkörper (30) und auf einem Träger (3), der eine Kontaktfläche (2) hat, befestigt ist, das mit einer anderen Kontaktfläche (1) versehen ist, auf der ein runder Draht (6), der ein freies Ende hat, befestigt ist, welcher runde Draht (6) ein zweites freies Ende (7) hat, wobei der gesamte runde Draht (6) mit einem Winkel (8) relativ zur Kontaktfläche (1), an der er befestigt ist, versehen ist, der ungefähr gleich dem Winkel (4) gewählt ist, den die Kontaktflächen (1,2) nach dem Befestigen des Elements (20) auf dem Träger (3) miteinander bilden.

9. Reihe optoelektronischer Halbleiterelemente (20) nach Anspruch 8, dadurch gekennzeichnet, daß die Reihe optoelektronischer Halbleiterelemente (20) sich auf einer Reihe von Trägerkörpern (30) befindet, die mit Bruchrändern miteinander verbunden sind.

## Revendications

1. Procédé pour la fabrication d'un dispositif semiconducteur opto-électronique (10) comprenant un élément semiconducteur opto-électronique (20), lequel élément semiconducteur opto-électronique (20) muni d'une première surface de contact (1) est fixé sur un support (3) muni d'une deuxième surface de contact (2), l'élément semiconducteur opto-électronique (20) étant fixé sur le support (3) de façon que les deux surfaces de contact (1,2) enferment entre elles un angle (4) qui diffère de zéro degrés et une connexion électrique entre les deux surfaces de contact (1,2) est formée par au moins un fil (6), caractérisé en ce que la connexion électrique (5) est formée du fait que, dans un appareil de soudage de fil, un fil rond (6) est muni d'une première extrémité libre qui est alors fixée à l'une des deux surfaces de contact (1, 2), tout le fil rond (6) est muni d'un angle (8) par rapport à la surface de contact (1, 2) à laquelle il est fixé, lequel angle est choisi pratiquement égal à l'angle (4) que forment lesdites surfaces de contact (1, 2) après la fixation dudit élément semiconducteur (20) sur ledit support (3), après la fixation de la première extrémité libre à l'une des surfaces de contact (1, 2), le fil rond (6) est muni d'une deuxième extrémité libre (7) et, après la fixation de l'élément semiconducteur opto-électronique (20) sur le support (3), la deuxième extrémité libre (7) du fil rond (6) est fixée à l'autre surface de contact (2,1).

2. Procédé selon la revendication 1, caractérisé en ce que le processus servant à munir le fil rond (6) de l'angle (8) et de la deuxième extrémité libre (7) et la fixation de la deuxième extrémité libre (7) du fil rond (6) à l'autre des deux surfaces de contact (2,1) sont effectués à l'aide de l'appareil de soudage de fil.

3. Procédé selon la revendication 1 ou 2, caractérisé en ce que la première extrémité libre du fil rond (6) est appliquée sur la première surface de contact (1) et par conséquent sur l'élément semiconducteur opto-électronique (20) avant la fixation de l'élément semiconducteur opto-électronique (20) sur le support (3).

4. Procédé selon la revendication 1, 2 ou 3, caractérisé en ce que l'élément semiconducteur opto-électronique (20) est fixé sur un corps de support (30) et le corps de support (30) est basculé et fixé au support (3) avec une surface latérale (9) qui enferme l'angle (4) avec la première surface de contact (1).

5. Procédé selon l'une des revendications précédentes, caractérisé en ce que l'angle (4) enfermé par les deux surfaces de contact (1,2) est choisi entre 10° et 90°.

6. Procédé selon l'une des revendications précédentes, caractérisé en ce qu'un appareil de soudage de fil par thermocompression ou par ultrasons est choisi comme appareil de soudage de fil.

7. Procédé selon l'une des revendications précédentes, caractérisé en ce qu'un laser à diode semiconductrice (20) est choisi comme élément semiconducteur opto-électronique (20).

8. Elément semiconducteur opto-électronique (20), fixé de préférence sur un corps de support (30) et fixé sur un support (3) présentant une surface de contact (2), muni d'une autre surface de contact (1) sur laquelle est fixé un fil rond (6) muni d'une première extrémité libre, lequel fil rond (6) présente une deuxième extrémité libre (7), tout le fil rond (6) étant muni d'un angle (8) par rapport à la surface de contact (1) à laquelle il est fixé et qui est choisi pratiquement égal à l'angle (4) enfermé par les surfaces de contact (1, 2) après la fixation de l'élément (20) sur le support (3).

9. Série d'éléments semiconducteurs opto-électroniques (20) selon la revendication 8, caractérisée en ce que la série d'éléments semiconducteurs opto-électroniques (20) est présente sur une série de corps de support (30) qui sont reliés entre eux à l'aide de bords de rupture.
